# EUROPEAN PATENT SPECIFICATION

(11) **EP 0 671 484 B1**
(45) Date of publication and mention of the grant of the patent: **10.09.1997**
(21) Application number: 94301700.4
(22) Date of filing: 10.03.1994
(51) Int. Cl.: C23C 16/44, C30B 25/14

(54) **Gas flow system for CVD reactor**
Gasleitungssystem für einen CVD-Reaktor
Système d'introduction de gaz dans un réacteur de dépôt chimique en phase vapeur

(43) Date of publication of application: 13.09.1995
(73) Proprietor: GI CORPORATION, Hatboro, Pennsylvania 19040 (US)
(72) Inventor: Chan, Joseph, Kings Park, New York 11754 (US); Garbis, Dennis, Huntington Station, New York 11746 (US); Sapio, John, Huntington Station, New York 11746 (US); Latza, John, Lindenhurst, New York 11757 (US)
(74) Representative: Allam, Peter Clerk

(56) References cited:
- US-A- 4 533 410
- US-A- 4 917 136
- PATENT ABSTRACTS OF JAPAN vol. 004, no. 048 (E-006) 12 April 1980 & JP-A-55 018 024 (CHIYOU LSI GIJUTSU KENKYU KUMIAI) 7 February 1980
- JOURNAL OF THE ELECTROCHEMICAL SOCIETY, MARCH 1985, USA, VOL. 132, NR. 3, PAGE(S) 662 - 668, ISSN 0013-4651 Tandon J L et al 'Large-scale growth of GaAs epitaxial layers by metal organic chemical vapor deposition'
- PT/ELEKTROTECHNIEK ELEKTRONICA, OCT. 1988, NETHERLANDS, VOL. 43, NR. 10, PAGE(S) 48 - 54, ISSN 0032-4086 van Sark W 'Study of high performance solar cell fabrication with UNIX and VME-bus process control'
- PATENT ABSTRACTS OF JAPAN vol. 013, no. 119 (C-579) 23 March 1989 & JP-A-63 291 895 (SUMITOMO METAL IND LTD) 29 November 1988

## Description

The present invention is concerned with chemical vapor deposition (CVD) reactors and more particularly relates to apparatus for growing epitaxial structures by chemical vapor deposition comprising a CVD reactor and a gas flow system connected thereto.

The invention enables us to provide apparatus of this kind which minimizes the deleterious residual effect of highly concentrated dopant gas in a reactor plumbing system and on the reactor chamber surface. By minimizing this deleterious residual effect, the impurity concentration of silicon epitaxial layers can be controlled in consecutive production runs.

Semiconductor devices such as diodes and power transistors are often fabricated on silicon wafers. To form the multiple layers of given resistivity and polarity necessary to obtain the devices, conventional diffusion processes are employed. The silicon wafer is masked and exposed to sources of various impurities level and type at elevated temperature. Thereafter the wafers are diced into individual chips which are connected to terminals and packaged.

The doped layer must be formed in a very precise manner. Otherwise, the physical and electrical properties of the resulting devices will not meet specification. Moreover, the fabrication of quality semiconductor devices must take place at a commercially acceptable yield rate.

Certain silicon wafers for use in making semiconductors are formed by an epitaxial process known as vapor deposition. The silicon layer is grown in a reactor chamber in which precise conditions can be maintained. These chambers are commonly called chemical vapor deposition (CVD) reactors.

In the CVD reactor, supply gases can be utilized in specific amounts and under specified temperatures and pressures to grow silicon layer with precisely controlled properties on a heavily doped silicon substrate. Conventionally, these are single layer epitaxial silicon wafers which must be transferred to a separate chamber called diffusion tube for formation of another doped layer. This is necessary for semiconductor fabrication.

Recently, a new all epitaxial process for growing a multilayer semiconductor structure has been developed. Such a process is described in our co-pending application 94 301 701.2 ( published under the number 0 671 770) corresponding to U.S. application 015,384 filed 9th February, 1993 and entitled "Multilayer Epitaxial Structure and Method for Fabricating Same". As described in detail in that application, the multilayer structure includes abrupt profile interfaces, a lightly doped layer and a relatively heavily doped, very low ohmic layer, for example with impurity concentrations in the order of 1 x 10¹⁹ per cm. The presence of such high impurity concentrations in a CVD reactor normally have adverse affects on subsequent productions runs in the reactor because of the so called residue "memory effect" of the dopant impurities remaining in the gas flow system and reactor chamber surfaces. These residual impurities may prevent precise resistivity control in subsequent processing in the chamber.

There will be described below a gas flow system embodying this invention for use with a CVD reactor which is employed in an epitaxial process where relatively heavy impurity concentrations of dopant impurities are present. The system significantly reduces the residual memory effect of the heavy impurity concentrations, leading to more precise resistivity control in subsequent production runs and thus higher quality wafers, resulting in higher device yields.

As compared to conventional CVD reactor gas flow systems the system is constructed to permit control of the supply of dopant source gases at a location in the main dopant gas supply line adjacent to the reactor input port as opposed to conventional CVD system where the gas mixing occurs in the gas control panel. In addition, the dopant gas supply line is separately vented from the other gas supply lines. Flow control devices, such as valves or check valves, etc., are located in the flow lines at places where gases might otherwise mix. Exhaust scrubber conditions are maintained such that adequate pressure conditions exist on all vent, purge and exhaust lines from the reactor in order to minimize or prevent back pressures and contaminations.

Gas flow systems for CVD reactors are disclosed in U.S. patent 4,533,410 (Ogura et al), published Japanese patent application JP-A-55-018 024 (see also related Patent Abstracts of Japan, Vol. 4, No. 48 (E-006), 12-04-80, and PT/Electrotechniek Electronika, Oct. 1988, Netherlands, Vol. 43, No. 10, pages 48-54. The first and third of these documents are particularly concerned with growing epitaxial materials by a MOCVD or MOVPE process - metal organic CVD and metal organic vapor phase epitaxy respectively. JP-A-55-018 024 discloses a vapor phase reactor in which the gas supply lines include the supply of HCl mixed with H₂ as an etchant gas and the disclosure is particularly directed to avoiding the etchant gas passing through a vacuum exhaust pump at the output port of the CVD reactor.

U.S. patent 4 533 410 discloses apparatus for growing epitaxial structures by chemical vapor deposition of the kind comprising a chemical vapor deposition reactor having an input port and an output port and a gas flow system including a main dopant gas supply flow line connected to said input port through a main dopant gas supply valve and a dopant gas vent line connected to said main dopant gas supply.

According to the present invention apparatus of the above kind is characterized in that said main dopant gas supply valve is connected adjacent said input port;
said main dopant gas supply vent line is connected to said main dopant gas supply line proximate said main dopant gas supply valve, and
said gas flow system further comprises:
three branch supply lines each having a respective valve therein connected to feed said main dopant gas supply line;
an etchant gas supply line connected to said input port;
a silicon gas supply line connected to said input port; and
a respective vent line connected to said etchant gas supply line and to said silicon gas supply line to provide venting separate from said main dopant gas supply vent line.

The etchant gas supply vent line and the silicon gas vent supply line may be connected to form a common vent line separate from the main dopant gas supply vent line.

For the control of the operation of the gas flow system various other valves may be provided. The embodiment to be described has a respective valve in each of the main dopant gas supply vent line, the etchant gas supply line and the silicon gas supply line. These valves may be solenoid valves.

The three branch lines above-mentioned may have two lines connected to respective sources of dopant gas and, preferably, each of these two lines is connected to feed the main dopant gas supply line through a respective check valve. The third branch line is connected to a source of diluent or purge gas such as hydrogen.

Apparatus comprising a gas flow system connected to a CVD reactor embodying the invention will now be described with reference to the accompanying drawings, wherein like numerals refer to like parts in which:
Fig. 1 is a schematic diagram illustrating the dopant supply control aspect of the gas flow system; and
Fig. 2 is a schematic diagram illustrating the overall gas flow system.

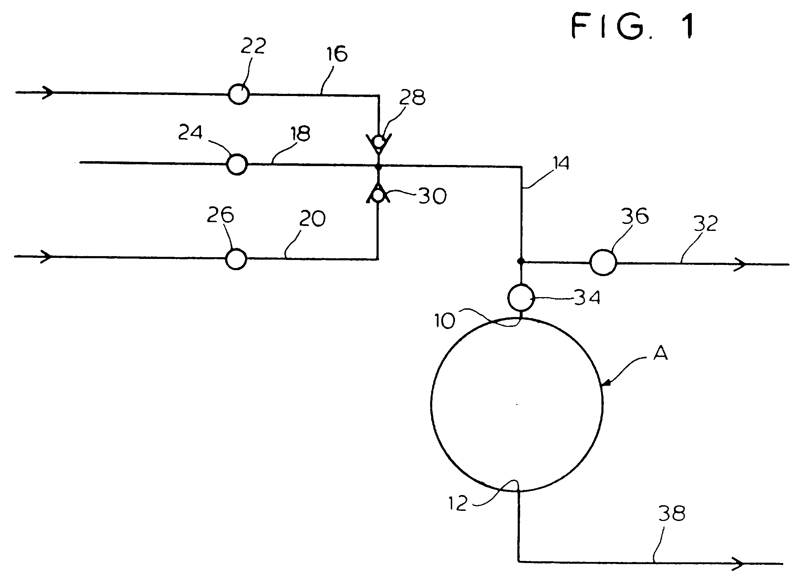

As seen in Fig. 1, the CVD reactor chamber, generally designated A, is provided with an input port 10 and an exhaust port 12, as is conventional. Input port 10 is connected to the dopant supply portion of the gas flow system which includes a main dopant gas supply line 14. Main supply line 14 in turn is fed by three branch supply lines 16, 18, 20. Branch lines 16 and 20, in the example are each connected to a different source of an impurity dopant gas, respectively, such as sources of gases containing boron or phosphorous. Branch line 18 is connected to receive a diluent gas, such as hydrogen, which may be mixed with the dopant gases prior to entering Chamber A or may be used as a purge.

Each branch supply line 16, 18 and 20 contains a solenoid valve 22, 24, and 26 respectively, which controls gas flow therein by opening and closing in response to the application of the appropriate electric signal. Further, check valves 28, 30 are situated in lines 16 and 20, respectively. The check valves are located proximate the point where the branch supply lines converge to form main dopant supply gas line 14.

Main dopant gas supply line 14 is connected to a vent line 32 which serves to vent all of the dopant gas supply lines. Vent line 32 is connected to main supply line 14 close to a solenoid valve 34 which controls the flow from the main supply line into input port 10. Valve 34 is located in main supply line 14 adjacent to input port 10. A solenoid valve 36 is also present in vent line 32. This configuration permits the entire supply line system to be thoroughly purged when required.

The exhaust portion of the gas flow system includes an exhaust line 38. Exhaust line 38 is connected to reactor output port 12.

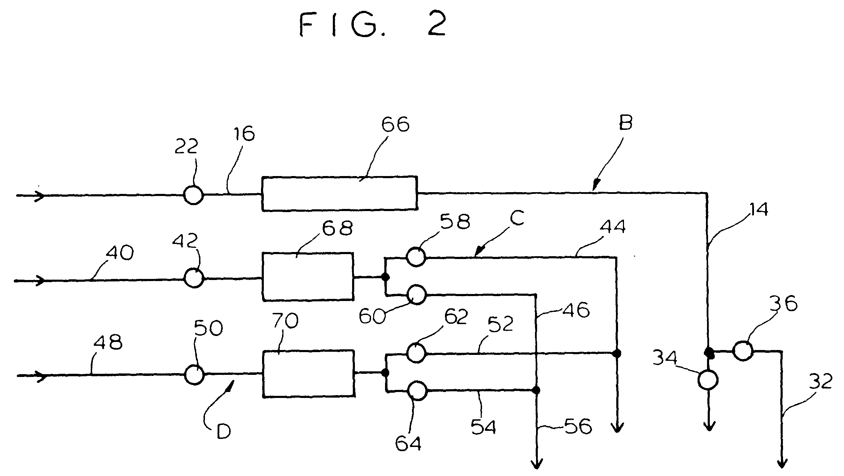

Fig. 2 illustrates the overall gas flow system. The dopant supply portion, generally designated B, is preferably as structured as illustrated in Fig. 1. However, for simplicity, the dopant gas supply is here illustrated as a single supply line 16. The etchant gas supply portion is generally designated C. The silicon source gas supply portion is generally designated D.

Etchant supply portion C includes a supply line 40 with a solenoid valve 42. Supply line 40 splits into a feed line 44 and a vent line 46. Similarly, silicon source gas supply portion D includes a supply line 43 with a solenoid valve 50. Line 48 splits into a feed line 52 and a vent line 54. Feed lines 44 and 52 are connected to the input port 10 of the reactor. Vent lines 46, 54 may be connected for form a common vent line 56. However, vent line 56 is separate from the dopant gas supply vent line 32.

Solenoid valves 58 and 60 are situated in lines 44 and 46 respectively. Solenoid valves 62 and 64 are situated in lines 52 and 54 respectively. Flow rate control devices 66, 68 and 70 of conventional design are situated in lines 16, 42 and 50 of each gas supply portion B, C and D, respectively, such that the rate of gas flow through each portion can be regulated precisely.

It will now be appreciated that there has been described a gas flow system for a CVD reactor in which the control valve for the dopant gas supply is located adjacent to the reactor chamber input port. Moreover, a separate vent line is provided for the dopant supply, the other gas supply lines having a different vent. Valves are strategically located to prevent gases from mixing. By appropriately pressurizing the system, this configuration minimizes back pressure and contaminations.

## Claims

1. Apparatus for growing epitaxial semiconductor structures by chemical vapor deposition, comprising a chemical vapor deposition reactor (A) having an input port (10) and an output port (12) and a gas flow system (B, C, D) including a main dopant gas supply flow line (14) connected to said input port through a main dopant gas supply valve (34) and a dopant gas vent line (32) connected to said main dopant gas supply line (14), characterized in that:
said main dopant gas supply valve (34) is connected adjacent said input port (10);
said main dopant gas supply vent line (32) is connected to said main dopant gas supply line (14) proximate said main dopant gas supply valve (34), and
said gas flow system further comprises:
three branch supply lines (16, 18, 20) each having a respective valve therein (22, 24, 26) connected to feed said main dopant gas supply line (14);
an etchant gas supply line (40) connected to said input port (10);
a silicon gas supply line (48) connected to said input port (10); and
a respective vent line (46, 54) connected to said etchant gas supply line (40) and to said silicon gas supply line (48) to provide venting separate from said main dopant gas supply vent line (32).

2. Apparatus as claimed in Claim 1 in which the etchant gas supply vent line (46) and the silicon gas supply vent line (54) form a common vent line (56) separate from said main dopant gas supply vent line (32).

3. Apparatus as claimed in Claim 1 or 2 in which said main dopant gas supply vent line includes a valve (36).

4. Apparatus as claimed in Claim 1, 2, 3 in which said etchant gas supply line includes a valve (42: 58).

5. Apparatus as claimed in Claim 1, 2 , 3 or 4 in which said silicon gas supply line includes a valve (50: 62).

6. Apparatus as claimed in any preceding claim in which each of two of said branch supply lines (16, 20) is connected to said main dopant gas supply flow line (14) through a respective check valve (28, 30).

7. Apparatus as claimed in Claim 6 in which said two branch supply lines (16, 20) are connected to a respective source of a dopant gas.

8. Apparatus as claimed in Claim 7 in which the third of said branch supply lines (18) is connected to a source of a diluent or purge gas.

9. Apparatus as claimed in any one of Claims 1 to 5 in which two of said three branch supply lines (16, 20) are connected to respective sources of dopant gas and the third branch supply line (18) is connected to a source of diluent gas.

## Patentansprüche

1. Vorrichtung zum Aufwachsen epitaktischer Halbleiterstrukturen durch chemische Abscheidung aus der Dampfphase, mit einem zur chemischen Abscheidung aus der Dampfphase dienenden Reaktor (A) mit einer Eingangsöffnung (10) und einer Ausgangsöffnung (12) und mit einem Gasströmungssystem (B, C, D), das eine Dotierungsgas-Hauptzufuhrströmungsleitung (14), die mit der Eingangsöffnung durch ein Dotierungsgas-Hauptzufuhrventil (34) verbunden ist, und eine mit der Dotierungsgas-Hauptzufuhrleitung (14) verbundene Dotierungsgas-Ventilationsleitung (32) aufweist,
**dadurch gekennzeichnet,**
daß das Dotierungsgas-Hauptzufuhrventil (34) angrenzend an die Eingangsöffnung (10) angeordnet ist;
daß die Dotierungsgas-Hauptzufuhrventilationsleitung (32) mit der Dotierungsgas-Hauptzufuhrleitung (14) nahe dem Dotierungsgas-Hauptzufuhrventil (34) verbunden ist, und
daß das Gasströmungssystem ferner aufweist:
drei Zweigzufuhrleitungen (16, 18, 20), in denen jeweils ein Ventil (22, 24, 26) vorgesehen ist, die zum Speisen der Dotierungsgas-Hauptzufuhrleitung (14) geschaltet sind;
eine Ätzgas-Zufuhrleitung (40), die mit der Eingangsöffnung (10) verbunden ist;
eine Siliziumgas-Zufuhrleitung (48), die mit der Eingangsöffnung (10) verbunden ist; und
eine jeweilige Ventilationsleitung (46, 54), die mit der Ätzgas-Zufuhrleitung (40) bzw. der Siliziumgas-Zufuhrleitung (48) verbunden sind, um eine Ventilation separat von der Dotierungsgas-Hauptzufuhrventilationsleitung (32) zu schaffen.

2. Vorrichtung nach Anspruch 1,
wobei die Ätzgaszufuhr-Ventilationsleitung (46) und die Siliziumgaszufuhr-Ventilationsleitung (54) eine gemeinsame Ventilationsleitung (56) bilden, die von der Dotierungsgas-Hauptzufuhrventilationsleitung (32) getrennt ist.

3. Vorrichtung nach Anspruch 1 oder 2,
wobei die Dotierungsgas-Hauptzufuhrventilationsleitung ein Ventil (36) beinhaltet.

4. Vorrichtung nach Anspruch 1, 2, 3,
wobei die Ätzgas-Zufuhrleitung ein Ventil (42, 58) beinhaltet.

5. Vorrichtung nach Anspruch 1, 2, 3 oder 4,
wobei die Siliziumgas-Zufuhrleitung ein Ventil (50, 62) beinhaltet.

6. Vorrichtung nach einem der vorausgehenden Ansprüche,
wobei zwei der Zweigzufuhrleitungen (16, 20) über ein jeweiliges Rückschlagventil (28, 30) jeweils mit der Dotierungsgas-Hauptzufuhrströmungsleitung (14) verbunden sind.

7. Vorrichtung nach Anspruch 6,
wobei die beiden Zweigzufuhrleitungen (16, 20) mit einer jeweiligen Quelle eines Dotierungsgases verbunden sind.

8. Vorrichtung nach Anspruch 7,
wobei die dritte der Zweigzufuhrleitungen (18) mit einer Quelle eines Verdünnungs- oder Spülgases verbunden ist.

9. Vorrichtung nach einem der Ansprüche 1 bis 5,
wobei zwei der drei Zweigzufuhrleitungen (16, 20) mit jeweiligen Dotierungsgasquellen verbunden sind und die dritte Zweigzufuhrleitung (18) mit einer Verdünnungsgasquelle verbunden ist.

## Revendications

1. Dispositif pour faire croître des structures épitaxiales de semi-conducteur par dépôt chimique en phase vapeur, comportant un réacteur (A) de dépôt chimique en phase vapeur ayant un orifice d'entrée (10) et un orifice de sortie (12) et un système d'écoulement de gaz (B, C, D) comportant une ligne principale (14) d'écoulement d'alimentation en gaz dopant reliée audit orifice d'entrée par l'intermédiaire d'une vanne principale (34) d'alimentation en gaz dopant et une ligne (32) de mise à l'air libre du gaz dopant reliée à ladite ligne principale (14) d'alimentation en gaz dopant, caractérisé en ce que :
ladite vanne principale (34) d'alimentation en gaz dopant est reliée en étant adjacente audit orifice d'entrée (10),
ladite ligne principale de mise à l'air libre (32) de l'alimentation en gaz dopant est reliée à ladite ligne principale (14) d'alimentation en gaz dopant à proximité de ladite vanne principale (34) d'alimentation en gaz dopant, et
ledit système d'écoulement de gaz comporte de plus :
trois lignes d'alimentation ramifiées (16, 18, 20) ayant chacune une vanne respective (22, 24, 26) connectée pour approvisionner ladite ligne principale (14) d'alimentation en gaz dopant,
une ligne (40) d'alimentation en gaz de gravure connectée audit orifice d'entrée (10),
une ligne (48) d'alimentation en silicium gazeux connectée audit orifice d'entrée (10), et
une ligne de mise à l'air libre respective (46, 54) connectée à ladite ligne (40) d'alimentation en gaz de gravure et à ladite ligne (48) d'alimentation en silicium gazeux pour fournir une mise à l'air libre séparée de ladite ligne principale de mise à l'air libre (32) de l'alimentation en gaz dopant.

2. Dispositif selon la revendication 1, dans lequel la ligne de mise à l'air libre (46) de l'alimentation en gaz de gravure et la ligne de mise à l'air libre (54) de l'alimentation en silicium gazeux forment une ligne de mise à l'air libre commune (56) séparée de ladite ligne principale de mise à l'air libre (32) de l'alimentation en gaz dopant.

3. Dispositif selon la revendication 1 ou 2, dans lequel ladite ligne principale de mise à l'air libre de l'alimentation en gaz dopant comporte une vanne (36).

4. Dispositif selon la revendication 1, 2, 3 dans lequel ladite ligne d'alimentation en gaz de gravure comporte une vanne (42, 58).

5. Dispositif selon l'une quelconque des revendications 1, 2, 3 ou 4, dans lequel ladite ligne d'alimentation en silicium gazeux comporte une vanne (50, 62).

6. Dispositif selon l'une quelconque des revendications précédentes, dans lequel chacune parmi deux desdites lignes d'alimentation ramifiées (16, 20) est connectée à ladite ligne principale (14) d'écoulement d'alimentation en gaz dopant à travers un clapet anti-retour respectif (28, 30).

7. Dispositif selon la revendication 6, dans lequel lesdites deux lignes d'alimentation ramifiées (16, 20) sont connectées à une source respective de gaz dopant.

8. Dispositif selon la revendication 7, dans lequel la troisième desdites lignes d'alimentation ramifiées (18) est connectée à une source de diluant ou de gaz de purge.

9. Dispositif selon l'une quelconque des revendications 1 à 5, dans lequel deux parmi lesdites trois lignes d'alimentation ramifiées (16, 20) sont connectées à des sources respectives de gaz dopant et la troisième ligne d'alimentation ramifiée (18) est connectée à une source de gaz diluant.
